Europäisches Patentamt

(19) European Patent Office

Office européen des brevets

(11) Numéro de publication: **0 074 322 B1**

(12) **FASCICULE DE BREVET EUROPEEN**

(45) Date de publication de fascicule du brevet:
02.05.91

(51) Int. Cl.⁵: **C23C 14/34**

(21) Numéro de dépôt: 82420124.8

(22) Date de dépôt: 26.08.82

(54) Couche de chrome de haute dureté, capable de résister à la fois à l'usure, à la déformation, à la fatigue des surfaces et à la corrosion.

(30) Priorité: 03.09.81 FR 8117040

(43) Date de publication de la demande:
16.03.83 Bulletin 83/11

(45) Mention de la délivrance du brevet:
02.05.91 Bulletin 91/18

(84) Etats contractants désignés:
CH DE GB IT LI SE

(56) Documents cités:
EP-A- 0 002 712
US-A- 3 428 541
US-A- 3 481 854
US-A- 3 912 612

MICROELECTRONICS AND RELIABILITY, vol. 12, no. 2, avril 1973, pages 111-117, Pergamon Press, GB; J.L. ABITA: "On sputtered thin-films of chrome, nitrided chrome and nickel-chromium"

PATENTS ABSTRACTS OF JAPAN, vol. 5, no. 20, 6 février 1981, page 692C42; & JP - A - 55 148 767 (TOKYO SHIBAURA DENKI K.K.) 19-11-1980

(73) Titulaire: **CENTRE STEPHANOIS DE RECHERCHES MECANIQUES HYDROMECANIQUE ET FROTTEMENT Société dite:**
**Zone Industrielle Sud Rue Benoît Fourneyron**
**F-42160 Andrezieux Boutheon(FR)**

Titulaire: **COMMISSARIAT A L'ENERGIE ATOMIQUE Etablissement de Caractère Scientifique Technique et Industriel**
**31/33, rue de la Fédération**
**F-75015 Paris(FR)**

(72) Inventeur: **Aubert, André**
**16 place Jean Moulins**
**Grenoble Isère(FR)**
Inventeur: **Chevallier, Jacques**
**5 rue de l'Oisans**
**Meylan Isère(FR)**
Inventeur: **Gaucher, Antoine**
**25 Avenue de Veauche**
**F-42160 Andrezieux Boutheon(FR)**
Inventeur: **Terrat, Jean-Paul**
**10 rue Etienne Boisson**
**Saint Etienne Loire(FR)**

IBM TECHNICAL DISCLOSURE BULLETIN, vol. 19, no. 9, février 1977, page 3621, New York, USA; J.J. DEMPSEY et al.: "Low stress chromium film"

JOURNAL OF APPLIED PHYSICS, vol. 43, no. 3, mars 1972, pages 794-799, USA; H.F. WINTERS: "Influence of surface absorption characteristics on reactively sputtered films grown in the biased and unbiased modes"

(74) Mandataire: **CABINET BONNET-THIRION**
**95 Boulevard Beaumarchais**
**F-75003 Paris(FR)**

## Description

On connaît le large usage qui est fait à l'heure actuelle des revêtements galvaniques de chrome dur pour améliorer la résistance à l'usure et la résistance à la corrosion des pièces mécaniques, notamment des pièces frottantes.

On connaît aussi les inconvénients et les limites de ce type de revêtement :

- dureté (1000 - 1100 HV en moyenne), certes supérieure à celle de la majorité des matériaux courants de construction mécanique, mais néanmoins insuffisante pour résister à des sollicitations sévères d'usure abrasive.
- tendance à la fissuration nécessitant, pour les applications en ambiance corrosive, de faire appel ou bien à des épaisseurs importantes de dépôt (ce qui est un handicap certain, compte-tenu de la faible vitesse de dépôt), ou bien à des sous-couches protectrices (nickel par exemple) qui grèvent d'autant le prix de revient des pièces traitées.
- influence néfaste sur la résistance à la fatigue des substrats revêtus, par suite de l'occlusion d'hydrogène dans la couche, ainsi que de la formation d'hydrates et d'oxydes.
- fragilité trop importante, entraînant l'éclatement de la couche en cas de déformation du substrat sous l'effet des contraintes normales et tangentielles combinées.
- pollution par le chrome VI contenu dans les effluents, nécessitant de coûteuses installations de neutralisation.

Certes, on connaît des procédés permettant de pallier l'un ou l'autre de ces inconvénients. Par exemple, la technique de dépôt physique en phase vapeur évite la pollution et conduit à des dépôts beaucoup moins fissurés que ceux qu' on sait réaliser par voie galvanique ; mais le chrome que l'on réalise ainsi est en général de faible dureté (500 à 600 Hv). Par exemple encore, les couches de carbures ou de nitrures de chrome offrent une dureté élevée et une bonne résistance à la corrosion, notamment lorsqu'elles sont mises en oeuvre par la technique de dépôt physique en phase vapeur, mais leur fragilité les rend inaptes à résister a une déformation, même peu importante du substrat, etc...

La présente invention propose une couche à base de chrome, pouvant être mise en oeuvre sur n' importe quel substrat et possédant à la fois tous les avantages des couches précédemment évoquées, tout en étant exempte de leurs inconvénients, c'est-à-dire qu'elle présente à la fois :

- une dureté très élevée (jusqu'à plus de 3000 HV),
- une absence de fissures (donc excellente protection du substrat contre la corrosion),
- pas de fragilisation du substrat par l'hydrogène, donc pas de diminution sensible de la résistance à la fatigue en volume des pièces traitées ; (cela va dans le même sens que l'absence de fissures dans la couche),
- une bonne aptitude à supporter sans se briser des déformations mêmes importantes du substrat,
- une résistance à la fatigue des surfaces, c'est-à-dire aux sollicitations répétées de frottement,
- de bonnes conductibilités thermique et électrique,
- pas de pollution (ni solide, ni liquide, ni gazeuse) lors de la mise en oeuvre.

A cet effet l'invention propose une couche de chrome de haute dureté, obtenue suivant une technique connue de pulvérisation cathodique dans une enceinte de traitement en atmosphère raréfiée, avec évaporation d'une cible de chrome, et dépôt sur un substrat quelconque conjointement avec du carbone qui est susceptible de former dans le chrome une solution solide d'insertion, couche caractérisée en ce que sa teneur en carbone est comprise entre deux limites, une limite supérieure $T_M$ à partir de laquelle le carbone et le chrome forment des phases et des composés correspondant au diagramme d'équilibre thermodynamique entre chrome et carbone, en l'espèce une teneur en carbone de 3 % en poids, et une limite inférieure $T_m$ qui est la teneur à saturation de la solution solide de carbone dans le chrome en équilibre thermodynamique, en l'espèce 0,2 % en poids.

L'invention propose également une couche de chrome de haute dureté, obtenue suivant une technique connue de pulvérisation cathodique dans une enceinte de traitement en atmosphère raréfiée, par évaporation d'une cible de chrome, et dépôt sur un substrat quelconque conjointement avec de l'azote qui est susceptible de former dans le chrome une solution solide d'insertion, couche caractérisée en ce que sa teneur en azote est comprise entre deux limites, une limite supérieure $T_M$ à partir de laquelle l'azote et le chrome forment des phases et composés correspondant au diagramme d' équilibre thermodynamique entre chrome et azote, en l'espèce 3,5 % en poids, et une limite inférieure $T_m$ qui est la teneur à saturation de la solution solide d'azote dans le chrome en équilibre thermodynamique, en l'espèce 0,04 % en poids.

Alors qu'on pourrait s'attendre à ce que la couche formée ait une composition conforme à celle qui serait prévisible par le diagramme d'équilibre thermodynamique chrome/élément d'addition, carbone ou azote, composition que l'on obtient effectivement lorsque les teneurs pondérales en élément d'addition sont, soit inférieures à $T_m$, soit supérieures à $T_M$, pour les teneurs spécifiées intermédiaires, on obtient des solutions solides d'insertion où l'élément d'addition vient se placer dans le réseau cristallin du chrome qui se trouve déformé, sans créer une nouvelle phase ou un nouveau composé tel que, pour le carbone, $Cr_{23}C_6$.

En deçà de $T_m$ l'élément d'addition forme dans le chrome une solution solide en équilibre thermodynamique. Au-delà de $T_M$, l'élément d'addition forme avec le chrome, des phases ou composés correspondant à ce que représentent les diagrammes d'équilibre thermodynamique.

Or, de façon tout à fait surprenante, les propriétés des couches de chrome formées lorsque leur teneur en élément d'insertion est comprise entre $T_m$ et $T_M$, sont tout à fait différentes, d'une part de celles obtenues en pulvérisant une cible de chrome en ambiance exempte de produits susceptibles de former avec le chrome des solutions solides d'insertion, d'autre part de celles obtenues lorsque la cible de chrome est pulvérisée en ambiance dont la teneur en ces mêmes éléments est telle qu'elle conduit à la formation d'une couche dont la teneur en élément d'insertion est supérieure à $T_M$ :

- en l'absence de produits susceptibles de former avec le chrome des solutions solides d'insertion, on obtient des couches de faible dureté (moins de 600 HV),
- au-delà d'une teneur en élément d'insertion égale à $T_M$, les couches formées voient leur fragilité s'accroître et leur résistance à la fatigue des surfaces diminuer de façon sensible.
- par contre, pour des teneurs en élément d'insertion comprises entre $T_m$ et $T_M$ , les couches formées possèdent simultanément toutes les propriétés précédemment énoncées.

Autrement dit, entre les deux teneurs $T_m$ et $T_M$ , on se place hors de l'équilibre thermodynamique. L'invention consiste à figer dans cet état cristallographique, des constituants qui se trouvent hors de l'équilibre thermodynamique.

Pour obtenir ce résultat, il est particulièrement favorable que la pression partielle en éléments réactifs dans l'ambiance de traitement, soit comprise entre $10^{-5}$ et $10^{-2}$ Torr ($1,33.10^{-3}$ à 1,33 Pa).

Si l'élément d'insertion du carbone ou une substance capable de libérer du carbone (par exemple du méthane ou de l'acétylène), on effectue la pulvérisation cathodique sous vide partiel dans une ambiance d'argon, à laquelle sont mélangés du méthane ou de l'acétylène.

Suivant une mise en oeuvre possible, et de façon non limitative, on expose à la pulvérisation cathodique des pièces qui ne sont initialement pas chauffées. Elles ne subissent que l'échauffement par rayonnement dû à la présence d'un plasma. Sur les appareils connus, on constate que cet échauffement par rayonnement porte la pièce à une température qui se stabilise naturellement à une température de l'ordre de 200° C.

Une fois effectuée la mise en place de la couche de chrome, on cesse la pulvérisation, et on laisse refroidir naturellement la pièce :

- soit en la laissant sous vide partiel ;
- soit à l'air ambiant si on a ouvert la machine.

On trouvera ci-après, à titre d'exemple non limitatif, la description des propriétés remarquables d'une couche mise en oeuvre conformément à l'invention, ladite couche étant à base de carbone. Des résultats du même type sont obtenus avec de l'azote, ou bien un mélange de carbone et d'azote et plus généralement toutes les fois que l'ambiance de traitement contient une substance capable de former avec le chrome des solutions solides d'insertion.

exemple :

Par technique de pulvérisation cathodique, , on a pulvérisé une cible de chrome sur des substrats en acier. La pulvérisation a été effectuée sous pression réduite d'environ $10^{-3}$ Torr (0,13 Pa) d'argon. On a ainsi réalisé sur les substrats des couches de 0,015 mm d'épaisseur, en 30 minutes environ de dépôt.

En opérant toujours dans les mêmes conditions opératoires (puissance de la décharge, distance pièce/cathode, tension de polarisation, etc...), on a comparé des couches exemptes de carbone (cas 1), des couches contenant 0, 18 % en poids de carbone (cas 2), des couches conformes à l'invention contenant 1,22 % en poids de carbone (cas 3) et des couches contenant 10 % en poids de carbone (cas 4). On a aussi fait des comparaisons avec une couche de chrome dur galvanique classique (cas 5).

On remarquera que dans les cas 1 et 2, la teneur en carbone de la couche est inférieure à $T_m$ ; dans le cas 3 elle est, conformément à l'invention, comprise entre $T_m$ et $T_M$ ; dans le cas 4 elle est supérieure à $T_M$.

Ces teneurs en carbone différentes d'une couche à l' autre ont été obtenues en faisant varier la pression partielle de carbone dans l'ambiance de traitement.

On a obtenu les résultats suivants :

a) microdureté moyenne de la couche (en degrés Vickers) :

| : Cas 1 : | Cas 2 : | Cas 3 : | Cas 4 : | Cas 5 : |
|---|---|---|---|---|
| : 600 : | 1310 : | 2200 : | 2600 : | 1000 – 1100: |

On remarquera que la couche conforme à l'invention (cas 3) a une dureté nettement supérieure à celle d'une couche exempte de carbone (cas 1) et nettement supérieure aussi à celle d'une couche de chrome dur galvanique classique (cas 5).

Par contre, lorsque la teneur en carbone est supérieure à $T_M$ (cas 4) la dureté s'accroît encore mais elle s'accompagne alors d'une fragilité due à la présence de carbure $Cr_{23}C_6$.

b) Résistance à la fatigue en volume :

Les éprouvettes essayées étaient du type flexion rotative en acier type 35 C D 4 trempé revenu à 570°C et tournant à 10.000 tours/minute.

| | : Cas 3 : | Cas 5 : |
|---|---|---|
| :Limite d'endurance | : 573,4 MPa : | 513,5 MPa : |

On notera l'amélioration sensible de résistance à la fatigue de la couche conforme à l'invention (cas 3) par rapport à une couche de chrome dur galvanique classique (cas 5).

c) Résistance à la déformation :

Celle-ci est illustrée par le test suivant où l'on utilise une lame en acier de 1 mm d'épaisseur et revêtue sur l'une de ses faces, soit d'une couche conforme à l'invention de 15 micromètres d'épaisseur de chrome obtenue par pulvérisation cathodique et contenant 1,22 % en poids de carbone (cas 3), soit d'une couche de chrome dur galvanique de même épaisseur. On lui fait subir une déformation par pliage (conditions d'essai identiques dans les deux cas, avec le même angle de pliage et la même vitesse de déformation).

Alors qu'aucun endommagement de la couche de chrome conforme à l'invention n'est observé après essai de pliage de la lame (la couche a suivi la déformation du substrat), la couche de chrome dur galvanique présente de très nombreuses traces d'exfoliation après pliage (la couche n'a pas pu suivre la déformation du substrat et s'est brisée, ce qui a entraîné l'apparition d'écaillage). Le même résultat (exfoliation et écaillage) est obtenu avec une couche du type du cas 4 (teneur en carbone> à $T_M$).

d) Résistance à la fatigue des surfaces :

Le principe de l'essai effectué, qui permet de quantifier des phénomènes tels que le pitting, consiste à appliquer des millions de fois, rigoureusement le même tenseur de contraintes dans un même micro-volume de l'éprouvette.

Dans cet essai, un pion en carbure de tungstène vient frapper de façon cyclique la même zone d'une éprouvette cylindrique en acier 35 C D 4 trempé revenu 570°C.

Lorsque l'éprouvette cylindrique est revêtue d'une couche de chrome dur galvanique de 15 micrometres d'épaisseur (cas 5), les premières apparitions du "pitting" surviennent après $5.10^6$ sollicitations, la contrainte appliquée étant ce 120 hbars (1,2 GPa).

Lorsque l'éprouvette est rvêtue d'une couche de chrome selon l'invention et contenant 1,22 % de carbone (cas 3), aucune apparition de "pitting" ne survient après $6.10^7$ sollicitations sous la même contrainte appliquée.

Avec une éprouvette revêtue d'une couche du type de celle du cas 4, les premières dégradations apparaissent après $9.10^6$ sollicitations.

e) Résistance à la corrosion :

En essai de corrosion au brouillard salin, les premières piqûres apparaissent après quelques dizaines d'heures d'exposition sur une éprouvette revêtue de 15 microns de chrome dur galvanique classique. Lorsque l'éprouvette est traitée conformément à l'invention, elle est toujours intacte après 150 heures d'exposition.

Remarque : Dans cet exemple, on notera que seule la couche conforme à l'invention (cas 3), satisfait simultanément à tous les impératifs de dureté, résistance à la déformation, résistance à la fatigue des surfaces, résistance à la corrosion

Les couches des cas 1, 2 et 5 sont moins dures. Celles des cas 4 et 5 résistent moins bien à la fatigue des surfaces, etc...

Suivant un second mode de réalisation possible, on procède par pulvérisation cathodique non réactive. Dans ce cas, l'élément d'insertion est apporté, non plus au niveau de l' ambiance gazeuse, mais il entre directement dans la composition de la cible cathodique.

Ainsi, à titre d'exemple, si l'élément d'insertion devant former avec le chrome une solution solide d'insertion est le carbone, celui-ci peut être apporté en mode réactif sous forme d'un hydrocarbure, tel le méthane, dans l'ambiance gazeuse. En mode non-réactif, celui-ci est introduit directement dans la cible sous forme élémentaire ; la cible est alors formée d'un mélange de chrome et de carbone (sous forme de graphite par exemple).

Suivant un autre exemple, si l'élément d'insertion devant former avec le chrome une solution solide d'insertion est le carbone, celui-ci peut être apporté en mode réactif sous forme d'un hydrocarbure, tel le méthane, dans l'ambiance gazeuse. En mode non-réactif, celui-ci est introduit directement dans la cible :
- soit sous forme élémentaire ; la cible est alors formée d'un mélange de chrome et de carbone (sous forme de graphite par exemple) ;
- soit sous forme de carbure ; la cible est alors formée d'un mélange de chrome et de carbure de chrome ($Cr_3 C_2$ par exemple).

Dans le cas de l'azote, cet élément est apporté par un nitrure. La cible est alors constituée d'un mélange de chrome et de nitrure de chrome ($Cr_2N$ par exemple).

Selon ce mode de réalisation par pulvérisation cathodique non-réactive, la couche obtenue est bien du type solution solide d'insertion. L'élément d'insertion présent dans la couche est dans les mêmes proportions que l'élément d'insertion présent dans la cible.

L'exemple ci-après illustre les propriétés d'une couche de chrome avec pour élément d'insertion le carbone.

Dans cet exemple de mise en oeuvre, on utilise un mode de pulvérisation cathodique non réactive. La cible est formée d'un mélange de chrome et de graphite dans les proportions en poids ci-après :

Cr :     98,80 %
C :      1,20 %

La couche obtenue par pulvérisation cathodique de cette cible contient 1,18 % de carbone. Sa microdureté est de 2.200 Vickers. Les propriétés en fatigue volumique, fatigue des surfaces, corrosion sont analogues à celles précédemment décrites.

Exemple de fabrication de couche de chrome de haute dureté en atmosphère non réactive :
Par pulvérisation cathodique on a pulvérisé une cible constituée d'un mélange de chrome et de carbure de chrome. Cette cible comporte 3,9 % en poids de $Cr_3C_2$ correspondant à environ 0,5 % de carbone dans la cible. Après une pulvérisation de 15 minutes, sous pression réduite d'environ $10^{-3}$ Torr d'argon (0,13 Pa), on obtient une couche de chrome de haute dureté de 0,010 mm contenant 0,45 % de carbone.

La microdureté, en degrés VIKERS, est de l' ordre de 1 500. Les autres propriétés sont du même ordre de grandeur que celles indiquées au cas 3 de l'exemple 1.

Exemple de fabrication d'une couche de chrome de haute dureté par pulvérisation cathodique réactive en présence d'azote :

Par pulvérisation cathodique réactive sous pression réduite de $2,2.10^{-3}$ Torr (0,29 Pa) environ d'argon contenant 10 % d'azote on a obtenu, après 25 minutes de pulvérisation une couche de haute dureté de 0,015 mm d'épaisseur contenant 1 % d'azote.

La microdureté en degrés VICKERS est de 1200; les autres propriétés étant du même ordre de

EP 0 074 322 B1

grandeur que celles indiquées au cas 3 de l'exemple ci-dessus (pages 5 et 6).

## Revendications

1. Couche de chrome de haute dureté, obtenue suivant une technique connue de pulvérisation cathodique dans une enceinte de traitement en atmosphère raréfiée, avec évaporation d'une cible de chrome, et dépôt sur un substrat quelconque conjointement avec du carbone qui est susceptible de former dans le chrome une solution solide d'insertion, couche caractérisée en ce que sa teneur en carbone est comprise entre deux limites, une limite supérieure $T_M$ à partir de laquelle le carbone et le chrome forment des phases et des composés correspondant au diagramme d'équilibre thermodynamique entre chrome et carbone, en l'espèce une teneur en carbone de 3 % en poids, et une limite inférieure $T_m$ qui est la teneur à saturation de la solution solide de carbone dans le chrome en équilibre thermodynamique, en l'espèce 0,2 % en poids.

2. Couche de chrome de haute dureté, obtenue suivant une technique connue de pulvérisation cathodique dans une enceinte de traitement en atmosphère raréfiée, par évaporation d'une cible de chrome, et dépôt sur un substrat quelconque conjointement avec de l'azote qui est susceptible de former dans le chrome une solution solide d'insertion, couche caractérisée en ce que sa teneur en azote est comprise entre deux limites, une limite supérieure $T_M$ à partir de laquelle l'azote et le chrome forment des phases et composés correspondant au diagramme d'équilibre thermodynamique entre chrome et azote, en l'espèce 3,5 % en poids, et une limite inférieure $T_m$ qui est la teneur à saturation de la solution solide d'azote dans le chrome en équilibre thermodynamique, en l'espèce 0,04 % en poids.

3. Couche de chrome selon les revendications 1 et 2 prises conjointement, caractérisée en ce qu'elle contient à la fois du carbone et de l'azote.

4. Couche de chrome selon l'une quelconque des revendications 1 à 3, caractérisée en ce que la pulvérisation cathodique est conduite en atmosphère dite réactive comportant du carbone et/ou de l'azote sous forme élémentaire ou combinée, entrant pour une pression partielle dans la composition de ladite atmosphère raréfiée.

5. Couche de chrome selon la revendication 4, caractérisée en ce que du carbone est sous forme combinée dans l'atmosphère raréfiée, cette forme combinée étant un hydrocarbure, tel le méthane.

6. Couche de chrome selon une quelconque des revendications 1 à 3, caractérisée en ce que la pulvérisation cathodique est conduite en atmosphère dite non réactive, carbone et/ou azote étant introduits au préalable dans la cible de chrome.

7. Couche de chrome selon la revendication 6, caractérisée en ce que le carbone est présent dans la cible sous forme élémentaire.

8. Couche de chrome selon la revendication 6, caractérisée en ce que carbone et azote sont présents dans la cible sous forme de composés, carbures et nitrures respectivement.

## Claims

1. A very hard chromium layer obtained by a known cathodic sputtering technique in a rarefied atmosphere in a treatment chamber by evaporation of a chromium target and deposition on any substrate conjointly with carbon which is capable of forming an inserted solid solution in the chromium, the layer being characterized in that its carbon content is between two limits, an upper limit $T_M$ above which the carbon and the chromium form phases and compounds corresponding to the thermodynamic equilibrium diagram obtained with chromium and carbon, in particular a carbon content of 3 % by weight, and a lower limit $T_m$ which is the thermodynamic equilibrium saturation content of the solid solution of carbon in chromium, in particular 0.2 % by weight.

7

2. A very hard chromium layer obtained by a known cathodic sputtering technique in a rarefied atmosphere in a treatment chamber by evaporation of a chromium target and deposition on any substrate conjointly with nitrogen which is capable of forming an inserted solid solution in the chromium, the layer being characterized in that its nitrogen content is between two limits, an upper limit $T_M$ above which the nitrogen and the chromium form phases and compounds corresponding to the thermodynamic equilibrium diagram obtained with chromium and nitrogen, in particular a content of 3.5 % by weight, and a lower limit $T_m$ which is the thermodynamic equilibrium saturation content of the solid solution of nitrogen in chromium, in particular 0.04 % by weight.

3. A chromium layer according to Claims 1 and 2 taken together, characterized in that it contains both carbon and nitrogen simultaneously.

4. A chromium layer according to any one of Claims 1 to 3, characterized in that the cathodic sputtering is performed in an atmosphere, called reactive, comprising carbon and/or nitrogen in elemental or combined form introduced to form a partial pressure in the composition of the said rarefied atmosphere.

5. A chromium layer according to Claim 4, characterized in that the carbon is in a combined form in the rarefied atmosphere, this combined form being a hydrocarbon such as methane.

6. A chromium layer according to any one of Claims 1 to 3, characterized in that the cathodic sputtering is performed in an atmosphere called non-reactive, the carbon and/or nitrogen being introduced previously into the chromium target.

7. A chromium layer according to Claim 6, characterized in that the carbon is present in the target in elemental form.

8. A chromium layer according to Claim 6, characterized in that the carbon and nitrogen are present in the target in the form of compounds, these being carbides and nitrides respectively.

## Ansprüche

1. Chromschicht hoher Härte erhältlich mittels bekannter kathodischer Pulverisierungstechnik durch Verdampfen einer Chromplatte in einem Behandlungsraum unter vermindertem Atmosphärendruck und Abscheiden auf einem beliebigen Substrat zusammen mit Kohlenstoff, der zur Ausbildung einer geschlossenen Feststofflösung in dem Chrom fähig ist, dadurch **gekennzeichnet,** daß ihr Kohlenstoffgehalt zwischen zwei Grenzwerten, einem oberen Grenzwert $T_M$, ab dem der Kohlenstoff und das Chrom Phasen und Verbindungen entsprechend dem thermodynamischen Gleichgewichtsdiagramm zwischen Chrom und Kohlenstoff ausbilden, hier bei einem Kohlenstoffgehalt von 3 Gew.-%, und einem unteren Grenzwert $T_m$, der der Sättigungsgehalt der festen Kohlenstofflösung im Chrom beim thermodynamischen Gleichgewicht ist, bei 0,2 Gew.-% liegt.

2. Chromschicht hoher Härte erhältlich mittels bekannter kathodischer Pulverisierungstechnik durch Verdampfen einer Chromplatte in einem Behandlungsraum unter vermindertem Atmosphärendruck und Abscheiden auf einem beliebigen Substrat zusammen mit Stickstoff, der zur Ausbildung einer geschlossenen Feststofflösung in Chrom fähig ist, dadurch **gekennzeichnet,** daß ihr Stickstoffgehalt zwischen zwei Grenzwerten, einem oberen Grenzwert $T_M$, ab dem der Stickstoff und das Chrom Phasen und Verbindungen entsprechend dem thermodynamischen Gleichgewichtsdiagramm zwischen Chrom und Stickstoff ausbilden, bei einem Stickstoffgehalt von 3,5 Gew.-%, und einem unteren Grenzwert $T_m$, der dem Sättigungsgehalt der festen Stickstofflösung im Chrom beim thermodynamischen Gleichgewicht, hier 0,04 Gew.-% entspricht, liegt.

3. Chromschicht nach den Ansprüchen 1 und 2, dadurch **gekennzeichnet,** daß sie zugleich Kohlenstoff und Stickstoff enthält.

4. Chromschicht nach einem der Ansprüche 1 bis 3, dadurch **gekennzeichnet,** daß die Kathodenpulverisierung in einer reaktiven Atmosphäre mit Kohlenstoff und/oder Stickstoff in elementarer oder gebundener Form durchgeführt wird, die bei einem Partialdruck der verminderten Atmosphäre in der Zusammensetzung eintritt.

5. Chromschicht nach Anspruch 4, dadurch **gekennzeichnet,** daß der Kohlenstoff in gebundener Form in der verminderten Atmosphäre als ein Kohlenwasserstoff, wie Methan vorliegt.

6. Chromschicht nach einem der Ansprüche 1 bis 3, dadurch **gekennzeichnet,** daß die Kathodenpulverisation in einer nichtreaktiven Atmosphäre durchgeführt wird, wobei der Kohlenstoff und/oder Stickstoff zuvor in die Chromplatte eingebracht wird.

7. Chromschicht nach Anspruch 6, dadurch **gekennzeichnet,** daß der Kohlenstoff in elementarer Form in der Platte vorliegt.

8. Chromschicht nach Anspruch 6, dadurch **gekennzeichnet,** daß Kohlenstoff und Stickstoff in der Platte in Form von Verbindungen, insbesondere von Karbiden bzw. Nitriden vorliegen.